# EUROPEAN PATENT APPLICATION

(11) **EP 4 607 276 A2**
(43) Date of publication of application: **27.08.2025**
(21) Application number: 25187778.3
(22) Date of filing: 07.07.2025
(51) Int. Cl.: G03F 7/00, G03F 9/00

(54) **METHOD FOR DETERMINING AN AERIAL IMAGE POSITION AND A LITHOGRAPHIC APPARATUS**

(71) Applicant: ASML Netherlands B.V., 5500 AH Veldhoven (NL)
(72) Inventor: MOEST, Bearrach, 5500 AH Veldhoven (NL); SIEBEN, Paul, 5500 AH Veldhoven (NL); NEEFS, Patricius, Jacobus, 5500 AH Veldhoven (NL); LOOMAN, Joris, Maria, Gerardus, 5500 AH Veldhoven (NL)
(74) Representative: ASML Netherlands B.V.

(57) **Abstract**

The disclosure provides a method of determining an aerial image position using at least one sensor on a substrate table of a lithographic apparatus, the method comprising: performing a first alignment measurement at a measure station of the lithographic apparatus to determine a position of the substrate relative to the at least one sensor; determining a first temperature of the at least one sensor during the first alignment measurement; performing a second alignment measurement at the expose station to determine a position of an aerial image of a reticle mark with respect to the at least one sensor; and
determining a second temperature of the at least one sensor during the second alignment measurement. The method includes correcting the second alignment measurement based on a difference between the first temperature and the second temperature.

## Description

### FIELD

The present disclosure relates to a method for determining an aerial image position. The disclosure also relates to a lithographic apparatus including a system for determining an aerial image position. The method and system may be suitable to align a patterning device, a beam of radiation, and a substrate intended to receive the radiation after it has been provided with a pattern using the patterning device. The patterning device may be a transmissive mask, or a reflective reticle.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Projection optics of the lithographic apparatus typically comprise a significant number of optical elements to project the radiation, provided with a pattern, onto a substrate. The pattern is typically provided using a transmissive patterned object, typically referred to as a mask, or a reflective patterned object, typically referred to as a reticle.

Due to the aspired nanometer sized patterns which have to be projected onto the substrate, even small aberrations in the projection optics may limit the accuracy of the projection. Also, the patterned object and the substrate need to be accurately aligned. The lithographic apparatus therefore typically includes sensors to measure all sorts of aspects of the process and of the apparatus at large. Said measurements can be done before, during and after processing of the substrate.

The measurements may include one or more sensor systems for, for instance, position measurement of a substrate on an object table, orientation measurement of the substrate, temperature measurement of the substrate, height measurement of a top surface of the substrate (typically referred to as a level sensor), image alignment (which relates to alignment of the projected image and the substrate), et cetera. Aberration measurements of the projection optics in the lithographic apparatus may also be included, which may allow to adjust the pattern and thereby correct potential aberrations in the projection optics.

An example of a method to use alignment sensors in a lithographic apparatus is disclosed in, for instance, patent application WO-2022/248154-A1.

As speed of processing is a key parameter, the lithographic apparatus typically includes at least two substrate tables which can operate in parallel. Typically, a first substrate table can be used to project the pattern, at a location which may be referred to as the expose side. At the same time, a second substrate table can load a new substrate and perform one or more measurements as exemplified above, at a location which may be referred to as the measure side.

A problem herein may arise when one or more sensor markers, i.e. markers at the level of the substrate table, may deform due to temperature change when the respective substrate table moves between the measurement side and the expose side. For instance, the shape and position of certain markers may be affected due to a temperature change and corresponding thermal deformation. Temperature changes may typically result from heating due to power consumption of equipment. The nanometer scale projections inherently mean that even the smallest aberrations in shape or position of the markers may negatively influence the accuracy of respective measurements.

For instance, the location and shape of image sensors in a substrate processing sequence may typically be determined at the measure side using a so called stage-align process. This process measures the location and shape of the substrate level sensor markers in horizontal and vertical direction. This measurement is typically done while the substrate table is located at the measure side. To determine the (horizontal) shape of the respective sensor, multiple alignment markers at sensor level may be measured, using an alignment module. The number of alignment markers may be two or more per sensor. To determine the vertical shape of a sensor or sensor markers at measure side, multiple lanes may be measured, for instance using a level sensor. The number of lanes may typically be about two to three.

From the stage align at the measure side, the horizontal and vertical shape of the respective sensor is estimated. This estimated shape is used on the expose side as a reference for inline actions, like lot correction and reticle align. However, the shape of the respective sensor changes between measure and expose, depending on the history.

In order to mitigate the history effect, the sequence is kept the same as much as possible for all wafers in a series of wafers. Nevertheless, thermal history effects of the sensor remain, which negatively affect the scan results. For instance, the sequence prior to expose side actions is not perfectly reproduced, leading to different measure-to-expose changes in the sensor for different wafers in a series. These changes are increased when multiple actions are performed on the expose side, like performing multi-image exposures. While these used to be rare, multi-image exposures have become more generic in state of the art lithographic systems. Also other factors can break the reproducibility for the sensor deformation between measure and expose side, such as idle time, calibrations, etc.

### SUMMARY

The present disclosure aims to provide a more accurate method and system for image alignment.

The disclosure provides a method of determining an aerial image position using at least one sensor on a substrate table of a lithographic apparatus, the method comprising the steps of:
arranging a substrate on the substrate table;
performing a first alignment measurement at a measure station of the lithographic apparatus to determine a position of the substrate relative to the at least one sensor;
determining a first temperature of the at least one sensor during the first alignment measurement;
moving the substrate table to an expose station of the lithographic apparatus;
performing a second alignment measurement at the expose station to determine a position of an aerial image of a reticle mark with respect to the at least one sensor; and
determining a second temperature of the at least one sensor during the second alignment measurement.

In an embodiment, the method includes the step of correcting the second alignment measurement based on a difference between the first temperature and the second temperature.

In an embodiment, the step of correcting the second alignment measurement includes correcting a position and/or shape of one or more sensor marks based on thermal deformation of the at least one sensor.

In an embodiment, correcting the position and/or shape of the one or more sensor marks includes a translation in a horizontal plane with respect to a midpoint of the respective sensor.

In an embodiment, the method includes the one or more sensor marks include at least one reflective mark.

In an embodiment, the one or more sensor marks include at least one transmissive mark, such as a grating.

In an embodiment, the step of correcting the second alignment measurement comprises using a model accounting for the temperature of the at least one sensor versus the location of the substrate table.

In an embodiment, the model uses temperature as a parameter.

In an embodiment, the first and second temperature act as an observer to the model.

According to another aspect, the disclosure provides a lithographic apparatus, comprising:
a substrate table being movable between a measure station and an expose station and comprising at least one sensor ;
the at least one sensor comprising at least one temperature sensor;
a controller connected to the at least one sensor, the controller being adapted for:
   performing a first alignment measurement when the substrate table is located at the measure station to determine a position of a substrate positioned on the substrate table relative to the at least one sensor;
   determining a first temperature of the at least one sensor during the first alignment measurement;
   performing a second alignment measurement at the expose station to determine a position of an aerial image of a reticle mark with respect to the at least one sensor; and
   determining a second temperature of the at least one sensor during the second alignment measurement.

In an embodiment, the controller is further adapted for correcting the second alignment measurement based on a difference between the first temperature and the second temperature.

In an embodiment, the at least one sensor is connected to the substrate table using one or more connectors having a first coefficient of thermal expansion which is smaller than a second coefficient of thermal expansion of the at least one sensor.

In an embodiment, the at least one sensor is adapted for thermal deformation in a horizontal plane with respect to the substrate table.

In an embodiment, the lithographic apparatus comprises:
an illumination system configured to condition a radiation beam;
a support structure constructed to support a patterning device, the patterning device being capable of imparting the radiation beam with a pattern in its cross-section to form a patterned radiation beam; and
a projection system configured to project the patterned radiation beam onto the substrate.

In an embodiment, the illumination system comprises a source of extreme ultraviolet light (EUV) adapted to provide the radiation beam.

### BRIEF DESCRIPTION OF THE DRAWINGS

Embocontrollerdiments of the invention will now be described, by way of example only, with reference to the accompanying schematic drawings, in which:
- Figure 1 depicts a lithographic system comprising a lithographic apparatus and a radiation source;
- Figure 2 depicts a perspective view of an exemplary substrate stage and projection system of a lithographic apparatus; and
- Figure 3 depicts a perspective view of an embodiment of a sensor system according to the disclosure.

### DETAILED DESCRIPTION

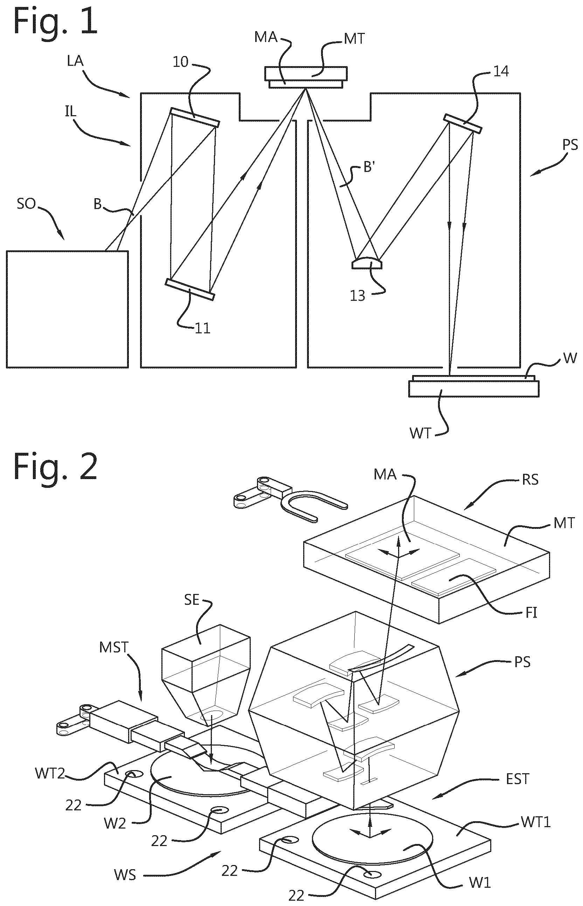

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

Figure 2 shows a reticle stage RS for supporting a patterning device MA such as a such as a reflective reticle or a transmissive mask. The patterning device herein below will be referred to as reticle. The method of the disclosure may likewise relate to a mask however.

Reticles and/or fiducials may be provided with a pellicle. The pellicle is a thin EUV transmissive membrane spaced apart from the object plane or reticle level so as to exclude contaminants. Pellicles may be comprised of a carbon nanotube-based composition..

The reticle is located in an object plane. A wafer stage WS may comprise two substrate stages WT1, WT2 which can function in parallel. Each substrate table may be movable, and can support a respective substrate W1, W2 in an image plane. Projection optics of the projection system PS are arranged to form an image of the object in the object plane in the image plane. The object and image planes are conjugate and may be referred to as field planes.

The substrate stage may be provided with a measurement station MST, also referred to as measurement side of the substrate stage. The measurement station may comprise sensing equipment SE for measuring certain qualities of a respective substrate W2 arranged on the corresponding substrate table WT2.

The substrate stage is typically also provided with an expose station EST for projecting an image onto a respective substrate using projection optics of the projection system PS. The expose station may also be referred to as the expose side of the substrate stage.

The one or more substrate tables WT1, WT2 can move with respect to each other and with respect to the measurement station and the expose station, enabling to measure and pre-condition one substrate at the measure station MST, while another substrate is being irradiated at the expose station EST.

The radiation beam B may be patterned by an object in the object plane. Said object may be a patterning device MA or a fiducial FI. The fiducial may be regarded as a standardized reticle, which may be build into the lithographic apparatus and can be used as a reference. The patterning device MA itself can be replaced, allowing to provide a pattern of choice to the beam of radiation.

To project patterns of a patterning device onto a respective substrate, it is important that a respective substrate is accurately aligned with the aerial image of the patterning device MA. Herein, please note that semiconductor devices typically require the projecting and deposition of multiple layers, up to hundreds of layers, on top of each other. Thus, each layer should be accurately aligned with the previous layer, to ensure that the subsequent layers can connect to each other for signal transfer. Mis-alignment of subsequent layers herein may be referred to as overlay error. Needless to say, overlay errors are preferably limited as much as possible and have an inherent upper limit depending on the size of projected lines, features and patterns.

The aerial image herein relates to the image of the pattern on the patterning device as projected onto the substrate. This requires, for instance, that the position of the respective substrate on a substrate table is accurately measured, and also that the aerial image of the patterning device is aligned with the measured position of the respective substrate on the substrate table. The respective measurements may typically involve one or more sensors 22 and markers, as described in more detail below. The one or more sensors may be positioned on respective substrate tables WT1, WT2.

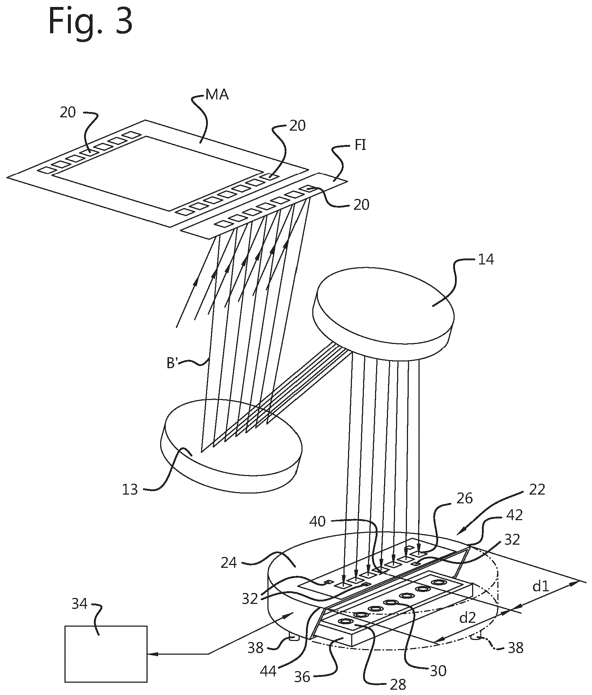

Referring to Figure 3, the reticle MA and fiducial FI may be provided with one or more first marks 20. In the present disclosure, the first marks may also be referred to as reticle level marks or reticle marks. The reticle marks may assist, for instance, with alignment of the aerial image of the reticle and a respective substrate.

The lithographic apparatus may comprise one or more sensors 22. The sensor 22 may comprise a sensor body 24, typically a housing of the sensor. The sensor may be provided with one or more second marks 26. The one or more second marks 26 may also be referred to as sensor level marks or sensor marks.

The one or more sensor marks 26 may be transmissive (such as a transmissive grating), reflective, or a combination of reflective and transmissive. The sensor marks 26 may combine one or more functionalities, i.e. may comprise different mark patterns or mark configurations, each intended for a different functionality, such as substrate positioning, aerial image alignment, etc. For the present disclosure, any variety, range or combination of sensor marks 26 may be conceivable. The key aspect is that the sensor 22 comprises one or more sensor marks 26.

For example, the sensor 22 may comprise one or more detectors 28 for detecting transmission 30 of radiation through one or more of the sensor marks 26. The respective sensor marks shown in Figure 3 are transmissive, and may typically comprise a grating pattern. However, detectors may also be located on other positions, for example to receive radiation as reflected from a respective sensor mark.

The sensor 22 may be provided with one or more temperature sensors or temperature measurement devices 32. The one or more temperature sensors 32 may, for instance, be located on a top end of the sensor die 24 facing the incoming patterned radiation. The temperature sensors 32 may be located relatively near to one or more of the respective sensor marks 26. The temperature sensors may be located in active areas of the sensor 22, wherein active means the sensor parts related to measuring such as the detector(s) or mark(s).

A controller 34 may be connected to the one or more sensors 22. The controlled may be adapted to receive measurement signals of respective temperature sensors 32 and detectors 28.

The sensor 22 may comprise a heat sink 36. The heat sink may for instance be arranged below the detectors 28. Alternative locations or additional heat sinks are also conceivable, for instance below the sensor body 24 and/or near electronics.

Electronics for driving and controlling the detector 28 may typically generate some heat during operation. The heat sink 36 may capture at least part of said heat and transport it away from critical processes or parts of the sensor. The heat sink in turn may dissipate the heat received from the electronics, for instance by heat exchange with a heat transport medium (not shown). The heat sink may comprise a material having relatively high thermal conductivity, such as aluminum or copper.

The sensor body 24 may be connected to another machine part, such as the substrate table WT, via one or more connectors 38. In an embodiment, three connectors 38 are provided around the perimeter of the body 24, at substantially equal mutual distances.

The temperature sensors 32 in the active areas of the sensor 22 allow to correct for thermal deformation of the sensor die 24. For instance, when the object table comprising the sensor 22 moves between the measure station and the expose station, a potential thermal deformation of the sensor can be corrected. The potential changes in the sensor may relate to, for instance, changes of the sensor body 24 and/or the sensor marks 26, such as horizontal location, shape in top view, or vertical displacement. Herein, respective measurements while a substrate table WT and the substrate loaded thereon are positioned in the measure station MST can be more accurately correlated to other measurements or actions when said substrate table has been moved to the expose station EST. A potential temperature difference between the two substrate table locations is used to correct, adapt or correlate the respective measurements.

According to an embodiment, an estimator may be included in the controller 34. The estimator may predict a shape of the sensor 22 and/or one of the sensor parts when the respective sensor 22 is located at the measure station. Herein, for instance, stage align is typically performed. The same estimator can be used to predict the shape of the same sensor when it is subsequently used at the expose station for inline actions like lot correction or reticle align.

Herein, reticle align may include alignment of the aerial image of a reticle mark 20 with one or more sensor marks 26. As the position of the substrate with respect to the sensor 22 was determined, alignment of the aerial image of the reticle mark(s) 20 with respect to the sensor mark(s) 26 may subsequently enable to align the aerial image of the reticle with the respective substrate. The method of the present disclosure herein enables to correct respective measurements for temperature changes of the sensor between respective measurements.

In an embodiment, the difference of the sensor shape as first predicted when the sensor was positioned on the measure side, and secondly predicted when the same sensor was positioned on the expose side, can be used as a correction to the expectation value for the measurement value of the sensor when it is positioned on the expose side. This is a preferred method.

According to another embodiment, the difference of the sensor shape as first predicted when the sensor was positioned on the measure side, and secondly predicted when the same sensor was positioned on the expose side, can be used as a correction of a modeled value. Herein, the modeled value can be based on the difference between the expected and measured value.

The temperature readings of the temperature sensors 32 can be used in different ways. For instance, embodiments of a method according to the present disclosure may include the steps of:
1. In a first step, the temperature sensor(s) 32 determine a first temperature value when the respective substrate table is located at the measure station. The temperature sensor(s) also measure a second temperature value when the substrate table is located at the expose side. The controller can determined the difference between the first and second temperature. The controller may use the temperature difference to calculate or determine the effective thermal deformation of the sensor marks 26. Effective expansion herein may at least relate to change of horizontal position or shape. The effective deformation of the sensor marks 26 accounts for a relation between free expansion of the sensor body 24 and the stress with respect to other parts. Finally, expected values are corrected based on the difference between the first and second temperature multiplied with said effective expansion.
   Herein, the controller is typically connected to the at least one sensor 22. The controller may typically be adapted for performing a first alignment measurement when the substrate table is located at the measure station to determine a position of a substrate positioned on the respective substrate table relative to the at least one sensor. Next, the controller may be adapted to determine a first temperature of the at least one sensor during the first alignment measurement. The controller may perform or assist in performing a second alignment measurement at the expose station to determine a position of an aerial image of one or more reticle marks with respect to the at least one sensor 22. Herein, the controller may be adapted to determine a second temperature of the at least one sensor during the second alignment measurement. Said second temperature is typically measured using temperature signals as provided by the one of more temperature sensors 36. The controller may be further adapted to correct the second alignment measurement based on the temperature difference between the first temperature and the second temperature.
2. Using a model accounting for the temperature of the sensor, for instance relating to shape of the sensor body 24 (also referred to as sensor die) and/or sensor marks 26, versus the location. Herein, the model may use heat input as a parameter. The heat input may be due to use of electronics for driving respective parts of the sensor 22. If the electronics to drive the detector(s) 28 are turned on, the electronics function as a source of heat, while the surrounding functions as a sink. Other sources of heat may include, but are not limited to, heat load from EUV radiation dose measurements at the expose side.

Heat transfers in accordance with modeled parameters and/or with the sensor body 24 functioning as a heat sink. The model may be tested and its parameters tuned in a test environment. During operation, the temperature sensors 32 provide input. For instance, the temperature sensors 32 measure temperature of the sensor 22 during operation, both while the substrate stage is at the measure station and while the substrate stage is at the expose station. The measured temperature values act as an observer to the model. The model may for instance use the measured temperature values to synchronize the observations (as included in the model) and the measured temperature values (as provided by the temperature sensors 32).

In both cases, the change in temperature of the sensor, as measured using the temperature sensors 32, between measure station MST and the expose station EST, is used to correct the observations and measurements made using the respective one or more sensors 22.

For instance, when the respective substrate table is located at the expose station, an objective is to align the respective substrate with the projected image (or aerial image) of the patterning device. According to the present disclosure, the temperature difference between the expose side and the measure side is used to correct the measurements at the expose side with a deformation or displacement of the image sensor and/or one or more of its components (such as the sensor marks 26) relative to the respective substrate.

In a practical embodiment, the sensor body 24 may be made of a material or material composition having a relatively low coefficient of thermal expansion. The body in turn may be connected to the respective substrate table using one or more relatively flexible connectors 38. The connectors 38 have a much higher coefficient of thermal expansion than the sensor body. In an embodiment, the body 24 is connected with such connectors at cylindrically symmetric locations, for instance at three or four locations along the perimeter of the body. Herein, thermal deformation of the sensor body 24 within a certain range can be controlled within a predictable range and within a predictable orientation. Said thermal deformation may, for instance, be limited to horizontal deformation with respect to the sensor mid point 40 within a certain temperature range.

This means, for instance, that upon heating within said temperature range, the middle 40 of the sensor body 24 will remain substantially stationary while opposite sides 42, 44 of the sensor body will move away from or towards said middle 40. See Figure 3. Thus, thermal deformation of the sensor body 24 will be substantially planar, extending in the horizontal plane. Only the distances d1, d2 between the mid point 40 of the sensor 22 and its respective sides 42, 44 will change. Said change may be substantially linear (in radial direction), within a certain range of temperatures. While the temperature of the sensor body remains within said temperature range, displacement in vertical direction such as buckling can be obviated.

In a practical embodiment, said temperature range (i.e. a difference between the first temperature at the measure station and the second temperature at the expose station) may be on the order of up to 10 milli-Kelvin or less, for instance about 0.001 to 100 micro-Kelvin, for instance about 1 to 100 nano-Kelvin.

In an embodiment, a method of the present disclosure operates within the temperature range wherein thermal expansion of the sensor body 24 is substantially linear. Linear herein means, on average, that the body 24 expands in the horizontal plane with a stable mid point 40. The one or more temperature sensors 32 may measure the temperature substantially constantly. Alternatively, distinct temperature measurements can be made, for instance when the sensor 22 (and the substrate table to which it is connected) are positioned at the expose side and the measure side respectively. At the measure side, the sensor 22 is used to measure, for instance, distance with respect to a substrate which has been positioned on the substrate table. Level sensors may be used to measure the vertical position of top surfaces of one or more of the substrate and the sensor(s) 22.

Subsequently, the substrate table is moved to the expose side, where the lithographic apparatus performs a measurement sequence to align an aerial image of the patterning device MA with the substrate. Said sequence may typically include steps wherein an aerial image of one or more reticle marks 20 are aligned with corresponding one or more sensor marks 26 (see Fig. 3). Herein, the alignment measurement may be corrected based on a potential temperature difference of the sensor 22 with respect to previous measurements when the sensor was located at the measure side.

In a preferred embodiment, and as long as said temperature difference remains within the aforementioned temperature range, the corrections may be limited to a substantially linear displacement (and corresponding correction) of respective sensor marks 26 with respect to the midpoint 40 of the sensor body 24. Due to the shape of the sensor (for instance circular as shown in Fig. 3, or rectangular), also a shape variation of the respective sensor marks 26 due to the thermal expansion with respect to the middle 40 of the sensor body 24 can be included.

During operation, typical changes in the shape of the sensor 22 due to thermal expansion may be of an order of magnitude of about 0.05 nm during a single reticle align measurement. Tests and computational modelling have indicated behavior of a multi-scan reticle align measurement (for instance including up to 10 measurements in sequence). Herein, a magnification as measured may change up to 0.025 ppm between a top scan and a bottom scan, or in other words up to about 0.3 nm at the sensor level. This means that for a regular reticle align, the impact would be up to about 0.03 nm systematic error for reticle align measurement (dual image, dual reticle). This error can be corrected, substantially entirely, using the method and system of the present disclosure.

The one or more sensors 22 as described herein above may include one or more transmission image sensors (TIS) or interferometric sensors for detecting reticle alignment (with the aid of the reticle level marks 20) and projection optics aberrations respectively. The latter may be referred to as an Integrated Lens Interferometry At Scanner (ILIAS) sensor. Multiple ILIAS sensors can be used in parallel, which may be referred to as a parallel ILIAS sensor or PARIS sensor. Please note that the ILIAS and PARIS sensors are typical for lithographic systems provided by the Applicant. Other sensors can be used as well, within the scope of the present disclosure. In particular, the present disclosure relates to sensors for aligning the projected image with the substrate whereon the image is to be projected.

Although specific reference may be made in this text to the use of lithographic apparatus in the manufacture of integrated circuits or other semiconductor related processing, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of determining an aerial image position using at least one sensor on a substrate table of a lithographic apparatus, the method comprising the steps of:
arranging a substrate on the substrate table;
performing a first alignment measurement at a measure station of the lithographic apparatus to determine a position of the substrate relative to the at least one sensor;
determining a first temperature of the at least one sensor during the first alignment measurement;
moving the substrate table to an expose station of the lithographic apparatus;
performing a second alignment measurement at the expose station to determine a position of an aerial image of a reticle mark with respect to the at least one sensor; and
determining a second temperature of the at least one sensor during the second alignment measurement.

2. The method of claim 1, including the step of correcting the second alignment measurement based on a difference between the first temperature and the second temperature.

3. The method of claim 2, wherein the step of correcting the second alignment measurement includes correcting a position and/or shape of one or more sensor marks based on thermal deformation of the at least one sensor.

4. The method of claim 3, wherein correcting the position and/or shape of the one or more sensor marks includes a translation in a horizontal plane with respect to a midpoint of the respective sensor.

5. The method of claim 3 or 4, wherein the one or more sensor marks include at least one reflective mark.

6. The method of one of claims 3 to 5, wherein the one or more sensor marks include at least one transmissive mark, such as a grating.

7. The method of one of claims 2 to 6, wherein the step of correcting the second alignment measurement comprises using a model accounting for the temperature of the at least one sensor versus the location of the substrate table.

8. The method of claim 7, wherein the model uses temperature as a parameter.

9. The method of claim 7 or 8, wherein the first and second temperature act as an observer to the model.

10. A lithographic apparatus, comprising:
a substrate table being movable between a measure station and an expose station and comprising at least one sensor ;
the at least one sensor comprising at least one temperature sensor;
a controller connected to the at least one sensor, the controller being adapted for:
performing a first alignment measurement when the substrate table is located at the measure station to determine a position of a substrate positioned on the substrate table relative to the at least one sensor;
determining a first temperature of the at least one sensor during the first alignment measurement;
performing a second alignment measurement at the expose station to determine a position of an aerial image of a reticle mark with respect to the at least one sensor; and
determining a second temperature of the at least one sensor during the second alignment measurement.

11. The lithographic apparatus of claim 10, the controller further adapted for correcting the second alignment measurement based on a difference between the first temperature and the second temperature.

12. The lithographic apparatus of claim 10 or 11, wherein the at least one sensor is connected to the substrate table using one or more connectors having a first coefficient of thermal expansion which is smaller than a second coefficient of thermal expansion of the at least one sensor.

13. The lithographic apparatus of one of claims 10 to 12, wherein the at least one sensor is adapted for thermal deformation in a horizontal plane with respect to the substrate table.

14. The lithographic apparatus of one of claims 10 to 13, comprising:
an illumination system configured to condition a radiation beam;
a support structure constructed to support a patterning device, the patterning device being capable of imparting the radiation beam with a pattern in its cross-section to form a patterned radiation beam; and
a projection system configured to project the patterned radiation beam onto the substrate.

15. The lithographic apparatus of claim 14, wherein the illumination system comprises a source of extreme ultraviolet light (EUV) adapted to provide the radiation beam.
